# EUROPEAN PATENT APPLICATION

(11) **EP 2 385 153 A1**
(43) Date of publication of application: **09.11.2011**
(21) Application number: 10735890.5
(22) Date of filing: 29.01.2010
(51) Int. Cl.: C23C 16/458, H01L 21/683

(54) **CVD APPARATUS**

(30) Priority: 30.01.2009 JP 2009019142
(71) Applicant: Toyo Tanso Co., Ltd., Osaka-shi Osaka 555-0011 (JP)
(72) Inventor: YOSHIMOTO, Yoshiaki, Kanonji-shi Kagawa 769-1612 (JP); KUBOTA, Takeshi, Kanonji-shi Kagawa 769-1612 (JP)
(74) Representative: Glawe, Delfs, Moll
(86) International application number: PCT/JP2010/051200
(87) International publication number: WO 2010/087428

(57) **Abstract**

A CVD apparatus is provided, that can remarkably improve the quality and productivity of susceptors without causing increase in production cost or increase in size of the apparatus. A CVD apparatus is provided, for forming a SiC film on a surface of a carbonaceous substrate (5) by introducing a gas into the apparatus while the carbonaceous substrate (5) is being supported by a support member. The support member has a lower portion support member (6) on which the carbonaceous substrate (5) is to be placed, the lower portion support member supporting a lower portion of the carbonaceous substrate (5), and an upper portion support member (13) supporting an upper portion of the carbonaceous substrate (5). The upper portion support member (13) is provided at an outer peripheral edge of the carbonaceous substrate (5). The upper portion support member (13) has a V-shaped groove (13d). The carbonaceous substrate (5) is disposed with sufficient clearance in a carbonaceous substrate-accommodating space (17) formed by the V-shaped groove (13d).

## Description

### TECHNICAL FIELD

The present invention relates to a CVD apparatus for forming a SiC film on a surface of a carbonaceous substrate.

### BACKGROUND WART

A susceptor used for semiconductor epitaxial growth, for example, is made of a material in which a SiC coating layer is formed on a surface of a carbonaceous substrate. The formation of the SiC film on the carbonaceous substrate surface is usually carried out by a CVD (chemical vapor deposition) technique, in which SiC is deposited on the carbonaceous substrate surface directly by causing a halogenated organic silicon compound containing a carbon source, such as hydrocarbon, to undergo a thermal decomposition reaction in a reductive gas flow. The formed SiC film needs to be formed in an extremely dense and uniform layer without any pin hole, in order to cover the entire surface of the carbonaceous substrate.

The formation or the SiC film has been carried out in such a condition that a carbonaceous substrate is oriented horizontally (i.e., laid down horizontally) while supporting the carbonaceous substrate at a plurality of points. This method, however, has the following problems.

(1) The SiC film is not formed at the support points. For this reason, in order to form the SiC film on the entire surface, it is necessary to open the CVD apparatus after forming the SiC film, then change the support points for the carbonaceous substrate, and form the SiC film again. This increases the manufacturing cost of the susceptor.

(2) Since the formation of the SiC film is carried out at high temperature, warpage occurs in the susceptor. The warpage is especially noticeable when the thickness of the susceptors is small. In addition, when the carbonaceous substrate is oriented horizontally in carrying out the film formation, the SiC film is formed in such a condition that particles exist on the carbonaceous substrate surface. For these reasons, the above-described method results in poor quality of the susceptor.

In view of the foregoing problems, it has been proposed to form the SiC film without opening the CVD apparatus by lifting the material to be processed (carbonaceous substrate) from the support blade temporarily and carrying out the operation of changing the contact positions of the material to be processed and the support blade in the middle of the CVD reaction. (See Patent Document 1 listed below.) However, even with such a proposal, the foregoing problem (2) cannot be resolved.

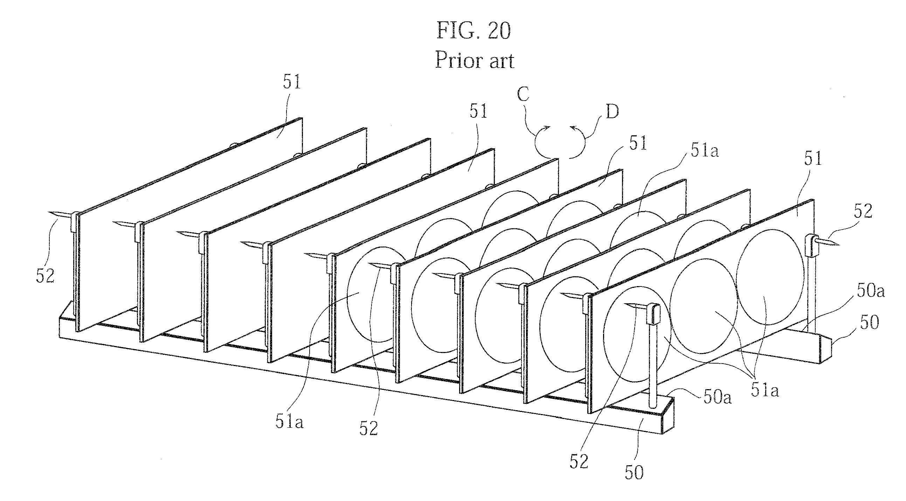

In view of such circumstances, it has been proposed to shift the supporting contact points for the carbonaceous substrate successively by suspending the carbonaceous substrate on a rotation support rod having a cross section smaller than the diameter of the through hole of the carbonaceous substrate (see Patent Document 2 listed below). With such a proposal, the foregoing problems (1) and (2) can be resolved. However, the proposal shown in Patent Document 2 can be applied only to the susceptor having a hole. Moreover, it requires an additional drive means, for example, for operating the rotation support rod, leading to other problems such as increase in the production cost of the CVD apparatus and increase in size of the CVD apparatus.
In view of this, a susceptor freestanding-type CVD apparatus as illustrated in Fig. 20 has been proposed. Specifically, in the CVD apparatus, carbonaceous substrates 51 are placed on knife-edge portions 50a of tapered-tip support pedestals 50, and opposite surfaces of each carbonaceous substrate 51 are supported by pins 52. Such a structure can be applied to even susceptors with no hole. Moreover, it eliminates the need of drive means for operating the rotation support rod. As a result, it is possible to prevent increase in the production costs of the CVD apparatus and increase in size of the CVD apparatus.

### CITATION LIST

### [PATENT DOCUMENTS]

[Patent Document 1]
   Japanese Published Unexamined Patent Application No. 2003-213429 A
[Patent Document 2]
   Japanese Published Unexamined Patent Application No. S63(1988)-134663 A

### SUMMARY OF THE INVENTION

### PROBLEMS TO BE SOLVED BY THE INVENTION

However, the above-described conventional structure is such that the opposite surfaces of the carbonaceous substrate 51 are merely supported by the pins 52. As a consequence, the carbonaceous substrate 51 can turn in the direction C or in the direction D, causing the substrate to shift in a diagonal direction, or to even fall over. When the carbonaceous substrate 51 falls over as in the latter case, the problem is not so serious if only one of the carbonaceous substrates 51 has fallen over. However, the falling-over of one of the carbonaceous substrates 51 may cause another carbonaceous substrate 51 adjacent thereto to fall over. As a consequence, a large number of the carbonaceous substrates 51 fall over, making it impossible to form desired SiC films. In addition, when the carbonaceous substrate 51 turns in such a manner as in the former case, the pins 52 may enter a recess 51a, causing uneveness in the film thickness of the SiC film to occur within the recess 51a and resulting in color unevenness.

Also, the CVD apparatus has such a structure that a SiC film is formed on the carbonaceous substrate 51 while the support pedestal 50 is being rotated. However, the flow quantity and the flow rate of the reacting source gas vary between the central portion and the peripheral portion in the CVD apparatus, because the central portion and the peripheral portion have different distances from the source gas supply unit. Thus, a problem has been that, if the carbonaceous substrates 51 are arrayed in a straight line as in the case of the conventional CVD apparatus, the coating film thickness can vary depending on the arrangement position of the carbonaceous substrate 51, and the amount of warpage in the recessed surface or the recess 51a can become considerably large.

In view of the foregoing circumstances, it is an object of the present invention to provide a CVD apparatus that can remarkably improve the quality and productivity of susceptors without causing increase in the production costs or increase in size of the apparatus.

### MEANS FOR SOLVING THE PROBLEMS

In order to accomplish the foregoing objects, the present invention provides a CVD apparatus for forming a SiC film on a surfaces of a carbonaceous substrate by introducing a gas into the apparatus while the carbonaceous substrate is being supported by a support member, **characterized in that**: the support member has a lower portion support member on which the carbonaceous substrate is to be placed, the lower portion support member supporting a lower portion of the carbonaceous substrate, and an upper portion support member supporting an upper portion of the carbonaceous substrate; the upper portion support member is provided at an outer peripheral edge of the carbonaceous substrate and has two support plates; and the carbonaceous substrate is disposed with sufficient clearance in a carbonaceous substrate-accommodating space formed between the support plates.

With the upper portion support member having the above-described structure, the supporting (retaining) of the carbonaceous substrate at its upper end is effected by two support plates. As a result, even if an external force acts on the carbonaceous substrate and the carbonaceous substrate undergoes rotation or displacement, the carbonaceous substrate can be prevented from falling over during the SiC film formation. Moreover, it is also possible to prevent the falling-over of another carbonaceous substrate adjacent to one of the carbonaceous from, which is caused by the falling-over of the one of the carbonaceous substrates.

In addition, the carbonaceous substrate is disposed between the support plates with sufficient clearance. As a result, when a gas is introduced into the apparatus, the wind force resulting from the gas flow causes the carbonaceous substrate to come into contact with one of the support plates of the upper portion support member or with the other support plate. That is, the carbonaceous substrate makes contact with the main portion of the upper portion support member intermittently. Therefore, the problem that a portion of the carbonaceous substrate cannot be coated can be avoided (i.e., the carbonaceous substrate surface is uniformly coated with the SiC film). Moreover, since the upper portion support member is provided at the outer peripheral edge of the carbonaceous substrate, it is possible to prevent the unevenness in the film thickness of the SiC film (and the color unevenness resulting therefrom), which is caused by the upper portion support member entering the recess in the carbonaceous substrate. Furthermore, the carbonaceous substrate is freestanding, and moreover, it is not completely fixed by the upper portion support member. As a result, the carbonaceous substrate is not affected by great external force, so the susceptor is prevented from warpage.

Accordingly, the susceptor manufactured by the CVD apparatus according to the present invention shows a less amount of warpage and a smaller percentage of color unevenness occurrence, resulting in good outer appearance. Thus, the quality of the susceptor can be improved.
Moreover, since the CVD apparatus according to the present invention does not require additional drive means such as the rotation support rod. As a result, the increase in the production costs of CVD apparatus and the increase in size of the CVD apparatus can be prevented.

It is desirable that the upper portion support member be disposed at an upper end position of the carbonaceous substrate.
When the arrangement position of the upper portion support member is set at a position other than the upper end position of the carbonaceous substrate, the tilt angle of the carbonaceous substrate becomes large. As a consequence, the carbonaceous substrate cannot swing with the wind force by the gas flow, causing the problem that a portion of the carbonaceous substrate cannot be coated. The just-described structure takes this problem into consideration. Moreover, the just-described structure is desirable in that the flow of the source gas to the susceptor is not impeded.

It is desirable that the clearance be from 1 mm to 2 mm.
If the clearance exceeds 2 mm, the tilt angle of the carbonaceous substrate becomes great, causing the problem that a portion of the carbonaceous substrate is not coated, as in the foregoing. On the other hand, if clearance is less than 1 mm, the source gas does not easily flow because the flow passage of the source gas is narrow, even though the substrate and the upper portion support member are not in contact with each other at all time, also causing the problem that a portion of the substrate is not coated. This is undesirable. Moreover, the processing accuracy of the upper portion support member needs to be increased, resulting in higher costs.

It is desirable that in the upper portion support member, the carbonaceous substrate-accommodating space formed by the two support plates of integral type have substantially a V-shape.
When the carbonaceous substrate-accommodating space formed by the two support plates has substantially a V-shape, the amount of the clearance can be adjusted merely by moving the upper portion support member upward and downward.

It is desirable that the lower portion support member have a pyrocarbon layer on a surface thereof.
With the above-described structure, the SiC film can be prevented from peeling off from the susceptor when the susceptor is removed from the lower portion support member, because the pyrocarbon material film is weaker in strength than the SiC film.

It is desirable that the lower portion support member have, on a surface thereof, a thermal expansion sheet on which a pyrocarbon layer is formed.
With the above-described structure as well, the SiC film can be prevented from peeling off from the susceptor when the susceptor is removed from the lower portion support member, for the same reason as described above. Moreover, in this case, the lower portion support member need not be replaced each time the film formed, and it is only necessary to replace the thermal expansion sheet on which the pyrocarbon layer has been formed, so the productivity is increased. Furthermore, the thermal expansion sheet shows high flexibility. Therefore, the cushioning capability is excellent when the carbonaceous substrate is mounted on the lower portion support member. As a result, when the substrate is mounted, chipping or the like in the carbonaceous substrate can be inhibited. In particular, when the carbonaceous substrate is large and heavy in weight, the just-described advantageous effects can be exhibited sufficiently.

It is desirable that when forming a SiC film on a surface of each of a plurality of the carbonaceous substrates, the carbonaceous substrates be disposed so as to be equidistant from the center of the apparatus.
In the CVD apparatus, the central portion of the CVD apparatus and the peripheral portion thereof have different distances from the source gas supply unit. However, when the carbonaceous substrates are disposed so as to be equidistant from the center of the apparatus, the differences in the distances from the source gas supply unit to the carbonaceous substrates, which depend on the arrangement positions of the carbonaceous substrates, are eliminated. Therefore, the amount of warpage can be reduced in every susceptor.

### ADVANTAGES OF THE INVENTION

The present invention exhibits a significant advantageous effect that it can remarkably improve the quality and productivity of susceptors without causing increase in the production costs or increase in size of the apparatus.

### BRIEF DESCRIPTION OF THE DRAWINGS

[Fig. 1] Fig. 1 is a perspective view illustrating the internal structure of a CVD apparatus according to the present invention.
[Fig. 2] Fig. 2 is a perspective view illustrating a lower portion support member.
[Fig. 3] Fig. 3 shows a lower portion support member, wherein Fig. 3(a) is a side view thereof, Fig. 3(b) is a front view thereof, and Fig. 3(c) is a cross-sectional view taken along line B-B in Fig. 3(b).
[Fig. 4] Fig. 4 is a perspective view illustrating a main portion of the lower portion support member.
[Fig. 5] Fig. 5 shows the main portion of the lower portion support member, wherein Fig. 5(a) is a side view thereof, Fig. 5(b) is a front view thereof, and Fig. 5(c) is a cross-sectional view taken along line A-A in Fig. 5(b).
[Fig. 6] Fig. 6 is a perspective view illustrating a contact point portion of the lower portion support member.
[Fig. 7] Fig. 7 shows the contact point portion of the lower portion support member, wherein Fig. 7(a) is a front view thereof, Fig. 7(b) is a bottom view thereof, and Fig. 7(c) is a side view thereof.
[Fig. 8] Fig. 8 shows an upper portion support member, wherein Fig. 8(a) is a front view thereof and Fig. 8(b) is a perspective view thereof.
[Fig. 9] Fig. 9 is an illustrative view showing the relationship between the upper portion support member and a carbonaceous substrate.

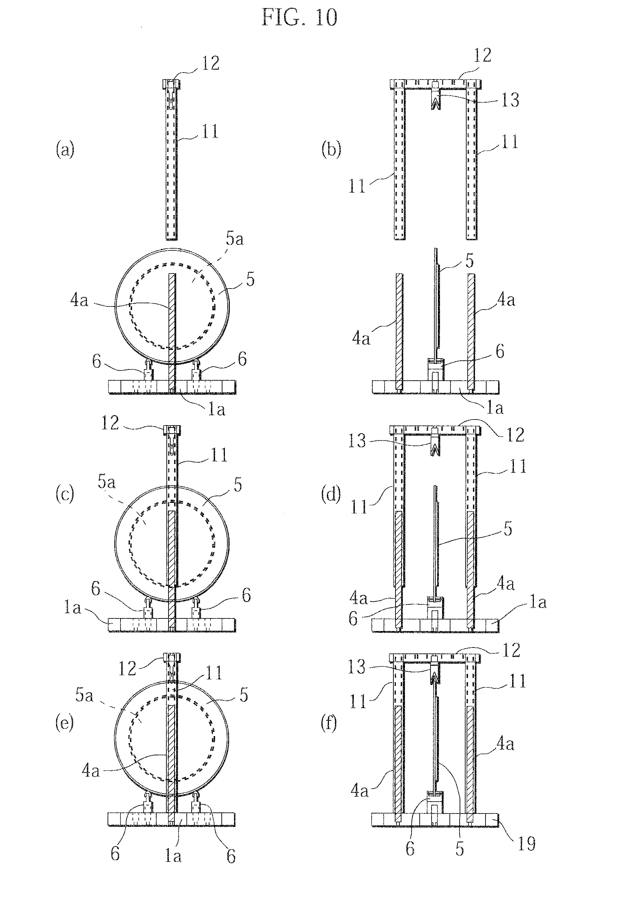

[Fig. 10] Fig. 10 shows a support procedure for a carbonaceous substrate, wherein: Figs. 10(a) and 10(b) are a front view and a side view, respectively, illustrating the condition in which the carbonaceous substrate and the upper portion support member have been disposed successively above the lower portion support member; Figs. 10(c) and 10(d) are a front view and a side view, respectively, illustrating the condition in which fitting rods are fitted into fitting tubes; and Figs. 10(e) and 10(f) are a front view and a side view, respectively, illustrating the condition in which the supporting of the carbonaceous substrate has been finished.
[Fig. 11] Fig. 11 is an illustrative view showing the relationship between the upper portion support member and the lower portion support member.
[Fig. 12] Fig. 12 is a perspective view illustrating a modified example of the internal structure of the CVD apparatus according to the present invention.
[Fig. 13] Fig. 12 is a perspective view illustrating another modified example of the internal structure of the CVD apparatus according to the present invention.
[Fig. 14] Fig. 14 is an illustrative view showing how a plurality of jigs may be disposed.
[Fig. 15] Fig. 15 is a front view illustrating a modified example of the upper portion support member.
[Fig. 16] Fig. 16 is a front view illustrating a modified example of the arrangement position of the upper portion support member.
[Fig. 17] Fig. 17 is an illustrative view showing the condition in which a pyrocarbon layer is formed on an outer surface of an expanded graphite sheet.
[Fig. 18] Fig. 18 is an illustrative view showing the relationship between the carbonaceous substrate and the upper portion support member when manufacturing a comparative susceptor Z3.
[Fig. 19] Fig. 19 is an illustrative view showing a warpage condition of a susceptor.
[Fig. 20] Fig. 20 is a perspective view illustrating the internal structure of a conventional CVD apparatus.

### BEST MODE FOR CARRYING OUT THE INVENTION

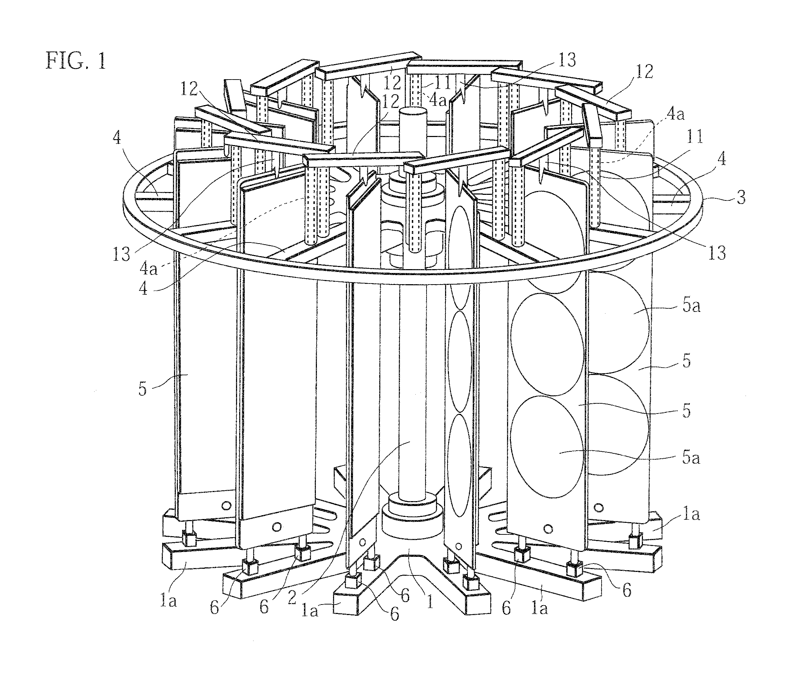

As illustrated in Fig. 1, a CVD apparatus according to the present invention has a pedestal 1, a support shaft 2 fixed to a central portion of the pedestal 1, support rods 4 extending radially from the support shaft 2, and a support ring 3 fixed to the outer ends of the support rods 4 to form an integral part with the support rods 4, which rotate together integrally when the apparatus is operated.

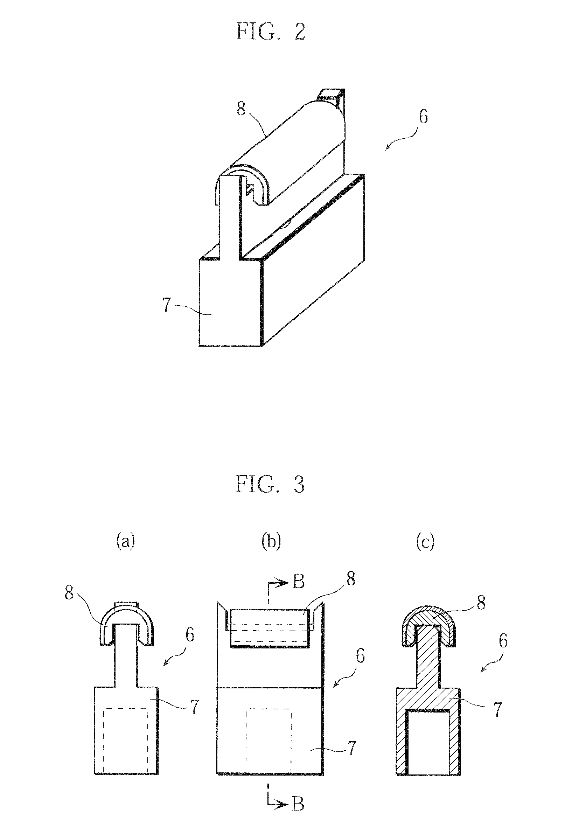

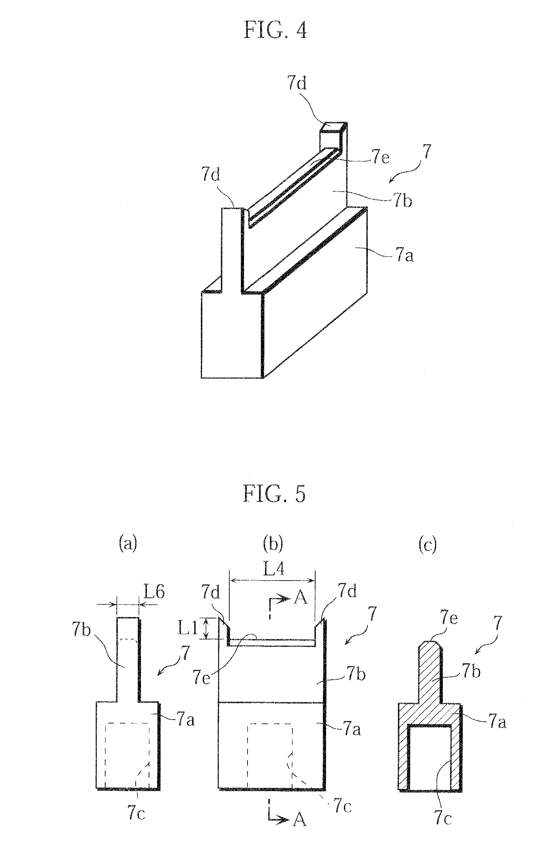

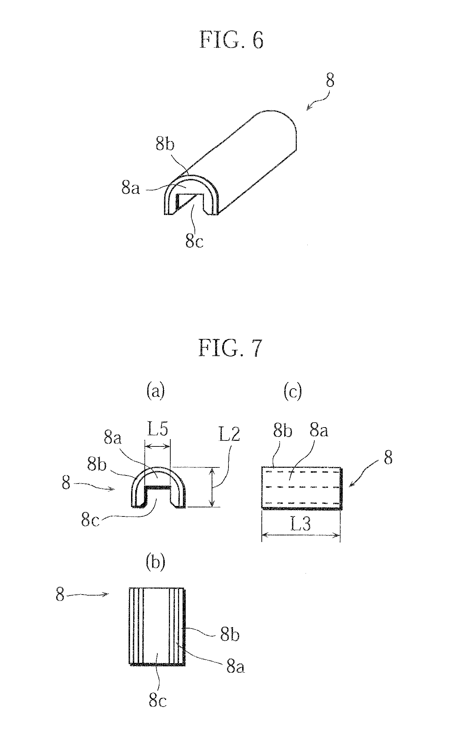

The pedestal 1 has extending portions 1a, and each extending portion 1a has, on a surface thereof, lower portion support members 6 for supporting a lower portion of a carbonaceous substrate 5, in which three recesses 5a are formed. Each of the lower portion support member 6 comprises, as illustrated in Figs. 2 and 3(a) to 3(c), a main portion 7 and a contact point portion 8 mounted over the main portion 7. As illustrated in Figs. 4 and 5(a) to 5(c), the main portion 7 has a base portion 7a having a hole 7c formed therein, which is to be fitted to a protuberance (not shown) protruding from the extending portion 1a of the pedestal 1 so as to be fixed to the pedestal 1, and a protruding portion 7b formed on the upper face of the base portion 7a and integrally with the base portion 7a. An upper face 7e of the protruding portion 7b serves as a mounting surface for mounting the contact point portion 8 thereon. The height L1 [see Fig. 5(b)] of protuberances 7d, formed at opposite ends of the upper face 7e, is set to be greater than the thickness L2 [see Fig. 7(b)] of the contact point portion 8. With such a structure, the carbonaceous substrate 5 comes into contact with the protuberances 7d even if the carbonaceous substrate 5 slightly tilts or moves when or after the carbonaceous substrate 5 is mounted on the surface of the contact point portion 8. As a result, the carbonaceous substrate 5 is prevented from tilting or moving further.

As illustrated in Figs. 6 and 7(a) to 7(c), the contact point portion 8 comprises a main portion 8a formed of graphite, and a pyrocarbon layer 8b formed on the outer surface of the main portion 8a. In addition, the contact point portion 8 has substantially a semicircular outer shape, and the length L3 [see Fig. 7(c)] thereof is configured to be slightly less than the length L4 [see Fig. 5(b)] of the upper face 7e of the protruding portion 7b. An angular C-shaped groove 8c is formed in the lower surface of the main portion 8a, and the width L5 thereof is configured to be slightly less than the width L6 [see Fig. 5(a)] of the upper face 7e of the protruding portion 7b. These two structures enable the contact point portion 8 to be arranged on the upper face 7e of the main portion 7 smoothly. Moreover, the strength of the pyrocarbon layer 8b is less than the SiC film formed by the CVD apparatus. This prevents the SiC film from peeling off from the carbonaceous substrate 5 when the carbonaceous substrate 5 is removed off from the CVD apparatus after forming the SiC film on the carbonaceous substrate 5. It should be noted that the pyrocarbon layer 8b is not necessarily formed only on the semicircular surface as described above, but may be formed on the entire outer surface of the main portion 8a.

The pyrocarbon layer 8b can be formed by commonly known methods. One example is shown below. First, the main portion 8a is disposed in a treating furnace, and a hydrogen gas or a hydrocarbon gas, such as methane gas or propane gas, is introduced in the furnace while the pressure in the furnace is kept at from 0.1 Torr to 10 Torr and the pressure in the furnace is kept at from 1600°C to 2000°C. Then, the gas undergoes thermal decomposition in the furnace. As a result, the thermally decomposed carbon builds up on the surface of the main portion 8a, forming the pyrocarbon layer 8b on the surface of the main portion 8a. It should be noted that, in order to increase the purity of the pyrocarbon layer 8b, it is desirable that after forming the pyrocarbon layer 8b, a heat treatment be carried out under a halogen gas atmosphere, such as carbon tetrachloride, at about 2000°C. Moreover, the deposition rate should be set slow, because otherwise, the carbon that builds up tends to be loose. Furthermore, the treatment needs to be carried out taking into consideration that varying the conditions such as the treatment temperature may result in a highly oriented structure or a turbostratic structure.

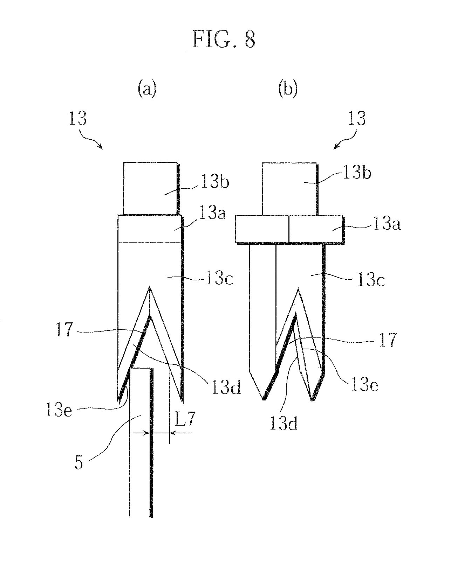

As illustrated in Fig. 1, columnar fitting rods 4a are provided upright on the upper faces of the support rods 4, and fitting tubes 11, having a slightly greater inner diameter than the diameter of the fitting rods 4a, are fitted on the fitting rods 4a. The fitting tubes 11 next to each other are fixed to each other by a connection rod 12. An upper portion support member 13 is fixed to the outer peripheral edge of the carbonaceous substrate 5 at substantially the central portion of the connection rod 12. As illustrated in Figs. 8(a) and 8(b), in the upper portion support member 13, a mounting portion 13b for mounting the upper portion support member 13 to the connection rod 12 is formed on the upper face of a base 13a, and a main portion 13c is formed on the lower surface of the base 13a. A lower portion of the main portion 13c has a V-shaped groove 13d for supporting the upper end of the carbonaceous substrate 5. The space formed by the groove 13d forms a carbonaceous substrate-accommodating space 17. The inner surface of the V-shaped groove 13d is made into a tapered knife-edge 13e, whereby its contact surface area with the carbonaceous substrate 5 can be made smaller and the thickness of the SiC film can be made more uniform. With the upper portion support member 13 having the above-described structure, the upper end of the carbonaceous substrate 5 is supported (retained) by two support plates (i.e., supported by two walls forming the V-shaped groove 13d, not by pins). Therefore, even when a force acts on the carbonaceous substrate 5 and the carbonaceous substrate 5 undergoes displacement, the carbonaceous substrate 5 can be prevented from falling over during the SiC film formation.

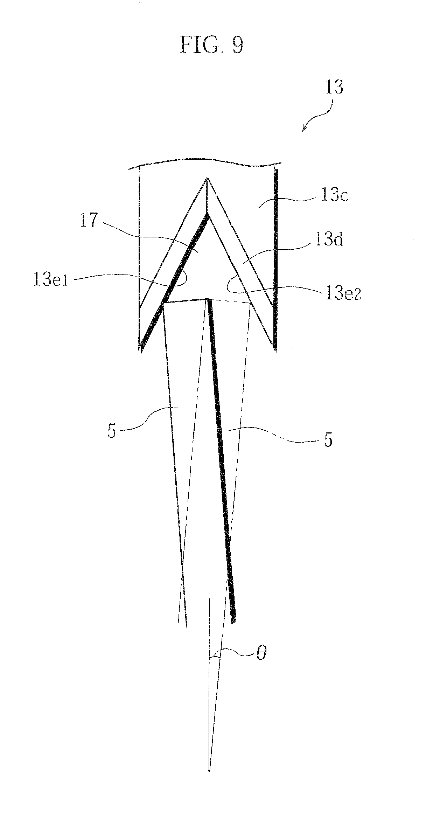

It is desirable that the distance L7 [see Fig. 8(a)] between the carbonaceous substrate 5 and the groove 13d be from about 1 mm to about 2 mm. The reason is as follows. Because of the gas flow in CVD apparatus and the rotational force of the apparatus, the carbonaceous substrate 5 turns as illustrated in Fig. 9, coming into contact with one of the knife-edges 13e₁ or with the other one of the knife-edges 13e₂. This makes it possible to avoid the problem that the SiC film is not formed on a portion of the carbonaceous substrate 5. However, if the distance L7 between the carbonaceous substrate 5 and the groove 13d is too great, the tilting angle θ of the carbonaceous substrate 5 accordingly becomes too large, preventing the carbonaceous substrate 5 from returning to the other one of the knife-edges by the gas flow in the CVD apparatus. As a consequence, the problem arises that the SiC film cannot be formed in a portion of the carbonaceous substrate 5. On the other hand, if the distance L7 between the carbonaceous substrate 5 and the groove 13d is restricted to be excessively small, the following problems arise. Even though the carbonaceous substrate 5 does not make contact with the groove 13d at all times, the flow passage of the source gas is so narrow that the coating is not effected. In addition, the groove 13d needs to be processed with higher processing accuracy, leading to higher costs.

With the just-described reasons, it may appear that the distance L7 between the carbonaceous substrate 5 and the groove 13d can be made longer if the length of the carbonaceous substrate 5 (the height thereof when it is freestanding) is greater. However, when taking into consideration the maximum length of the carbonaceous substrate 5 that is used currently, it is desirable that the upper limit of the distance L7 be 2 mm.

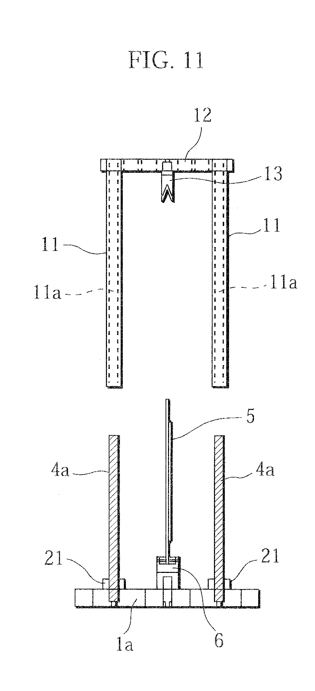

Next, how the carbonaceous substrate 5 is arranged will be described with reference to Figs. 10(a) to 10(c). For simplicity of illustration, the following describes a case in which the number of recesses 5a is one.
First, as illustrated in Figs. 10(a) and 10(b), the carbonaceous substrate 5 is disposed on the lower portion support members 6, and further, upper portion support member 13 is disposed on the carbonaceous substrate 5. Next, as illustrated in Figs. 10(c) and 10(d), fitting tube 11 having an inner diameter slightly larger than the diameter of the fitting rod 4a is fitted onto the fitting rod 4a. When the fitting is finished, the preparation completed state is reached, as illustrated in Figs. 10(e) and 10(f). It should be noted that, when the distance L7 between the carbonaceous substrate 5 and the groove 13d of the upper portion support member 13 becomes too small, it is possible to adjust the distance L7, for example, by fitting a ring-shaped adjusting member 21 onto the fitting rod 4a, as illustrated in Fig. 11.

### (Other Embodiments)

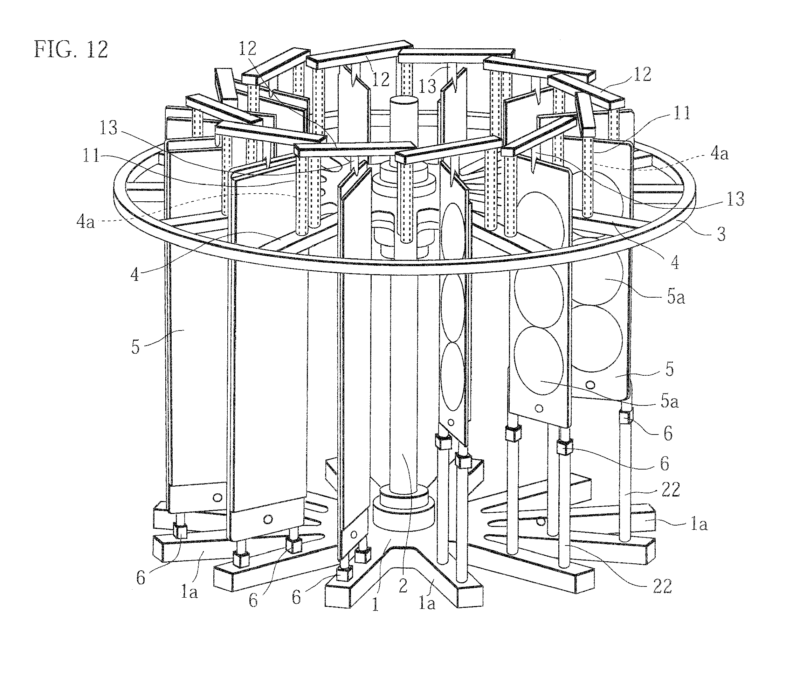

(1) As illustrated in Fig. 12, the lower portion support members 6 may not be disposed directly on the extending portions 1a of the pedestal 1, but the lower portion support members 6 may be disposed via extendable/shrinkable support rods 22. In this way, short-length carbonaceous substrates 5 can also be handled. Therefore, even when there are smaller lot products, they can be processed with larger lot produces at the same time, so the productivity can be further improved.

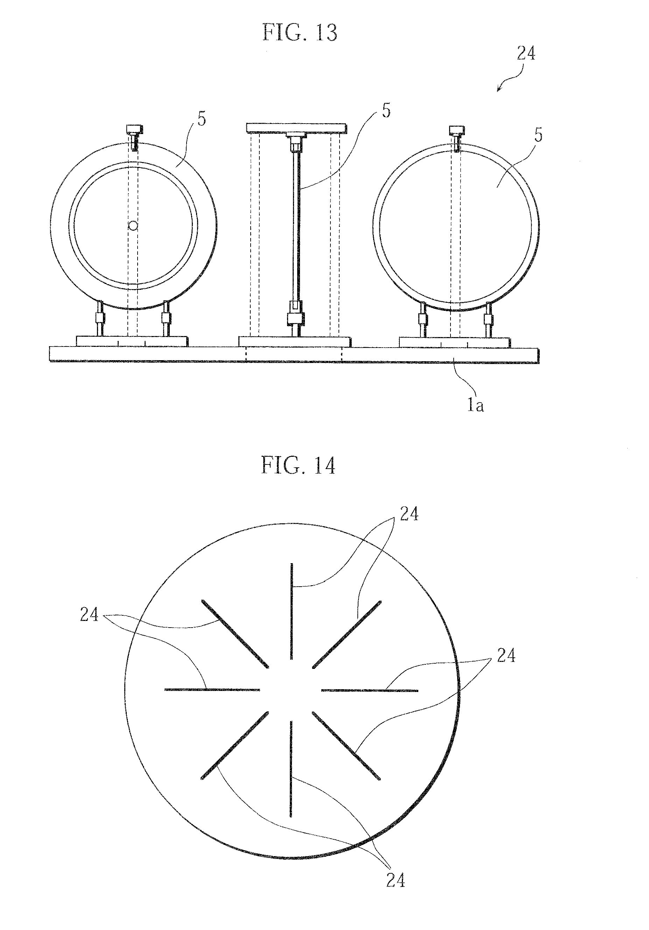

(2) As illustrated in Fig. 14, it is possible to dispose a plurality of jigs 24 radially and dispose the carbonaceous substrates 5 in the directions parallel to and perpendicular to the radial directions as shown in Fig. 13, to carry out the SiC film formation process.

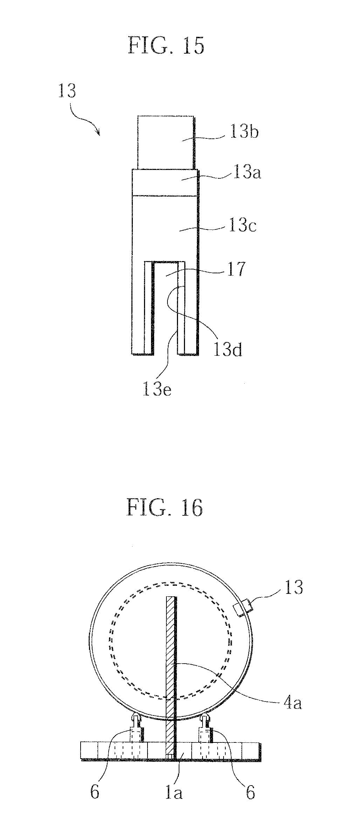

(3) The groove 13d formed in the upper portion support member 13 is not limited to the V-shaped groove, but may have an angular C-shape or a 11-shape, as illustrated in Fig. 15. However, if such structures are employed, the distance L7 between the carbonaceous substrate 5 and the groove 13d cannot be varied. Therefore, such structures are applicable only to the carbonaceous substrates 5 that have the same thickness.

(4) The arrangement position of the upper portion support member 13 is not limited to the upper end of the carbonaceous substrate 5, but may be an intermediate position of the carbonaceous substrate 5, as illustrated in Fig. 16. However, in this case, the angle θ shown in Fig. 9 becomes large even when the distance L7 between the carbonaceous substrate 5 and the groove 13d is set at from 1 mm to 2 mm as described above. Therefore, it is most desirable that the arrangement position of the upper portion support member 13 be the upper end of the carbonaceous substrate 5.

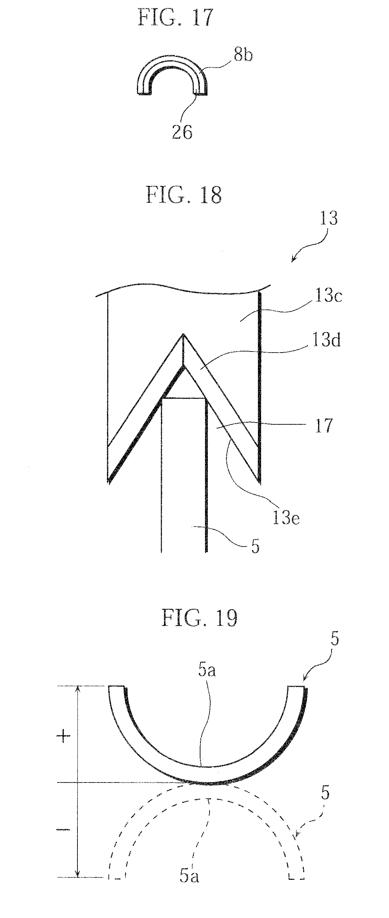

(5) In the contact point portion 8, the pyrocarbon layer 8b is directly formed on the outer surface of the main portion 8a, but such a structure is illustrative only. As illustrated in Fig. 17, it is also possible that that the pyrocarbon layer 8b may be formed on the outer surface of an expanded graphite sheet 26 having an inner shape that is the same as the shape of the main portion 8a, and thereafter, this may be laid over the outer surface of the main portion 8a. The expanded graphite sheet 26 is a sheet-shaped graphite product that is fabricated by subjecting acid-treated flaked natural graphite to a high-temperature expansion treatment, and compressing and pressurizing it. The expanded graphite sheet 26 has flexibility. The sheet should preferably be a high-purity product containing little impurities. Specifically, it is desirable that the content of impurities be 20 ppm or less, preferably 10 ppm or less, even more preferably 5 ppm or less. Moreover, the pyrocarbon layer 8b may be formed in the same manner as used for forming the pyrocarbon layer 8b directly on the outer surface of the main portion 8a.
(6) In the upper portion support member 13 having the above-described structure, the two support plates (i.e., the two walls that form the V-shaped groove 13d) are formed integrally. However, the two support plates are not limited to having such a structure, but the two support plates may be formed by separate parts.

### EXAMPLES

Hereinbelow, the present invention will be described in further detail based on examples thereof. However, the CVD apparatus is not limited by the description of the following examples.

### [Example 1]

A susceptor was fabricated using a CVD apparatus described in the description of the foregoing section BEST MODE FOR CARRYING OUT THE INVENTION. The carbonaceous substrate (susceptor) used had a diameter of 8 inches and a thickness of 6 mm. This also applies to the following Example 2 and Comparative Examples 1 to 3.
The susceptor fabricated in this manner is hereinafter referred to as a present invention susceptor A1.

### [Example 2]

A susceptor was fabricated using a CVD apparatus described in paragraph (5) of (Other Embodiments) in the foregoing section BEST MODE FOR CARRYING OUT THE INVENTION.
The susceptor fabricated in this manner is hereinafter referred to as a present invention susceptor A2.

### [Comparative Example 1]

A susceptor was fabricated using a CVD apparatus in which a carbonaceous substrate was disposed horizontally (i.e., laid down horizontally) while the carbonaceous substrate was being supported at a plurality of points by support pins.
The susceptor fabricated in this manner is hereinafter referred to as a comparative susceptor Z1.

### [Comparative Example 2]

A susceptor was fabricated using a CVD apparatus described in the section BACKGROUND ART with reference to Fig. 20.
The susceptor fabricated in this manner is hereinafter referred to as a comparative susceptor Z2.

### [Comparative Example 3]

A susceptor was fabricated using a CVD apparatus in which the carbonaceous substrate 5 was brought into contact with the main portion 13c of the upper portion support member 13 at all times and in which the pyrocarbon layer 8b was not formed on the outer surface of the main portion 8a of the lower portion support member 6, as illustrated in Fig. 18.
The susceptor fabricated in this manner is hereinafter referred to as a comparative susceptor Z3.

### [Experiment 1]

The amount of warpage, the percentage of color unevenness occurrence, appearance, and whether or not the SiC film has peeled off were for the present invention susceptors A1 and A2 as well as the comparative susceptors Z1 to Z3. The results are shown in Table 1 below. The experiment conditions (film formation conditions) were as follows.

### - Experiment Conditions

Pressure in the apparatus: 0.1 Torr to 760 Torr
Temperature in the furnace: 1150C° to 1500C°
Introduced gas: CH₃SiCl₃ (methyltrichlorosilan) and hydrogen gas as a carrier gas
Film thickness of the SiC film: 40 µm to 60 µm

**[TABLE 1]**

| Susceptor | Mounting method of susceptor | Jig | | Test results | | | |
|---|---|---|---|---|---|---|---|
| | | Upper jig | Lower jig | Amount of warpage* (mm) | Percentage of color unevenness occurrence | Appearance | SiC film peeling |
| A1 | Freestanding | Does not make contact at all times | Two points. Pyrocarbon layer 8b is formed on graphite jig (main portion 8a). | -0.10 to +0.10 | 9% | Good | No |
| A2 | Freestanding | Does not make contact at all times | Two points. Expanded graphite sheet 26 and pyrocarbon layer 8b are provided on graphite jig (main portion 8a). | -0.10 to +0.10 | 9% | Good | No |
| Z1 | Horizontally-oriented | None | Back side is supported at several points. | -3.00 to +3.00 | 100% | Poor | Yes |
| Z2 | Freestanding | None. Both sides of the susceptor are supported by pins. | Graphite jig has knife-edges. Graphite jig surface is not treated (has no pyrocarbon layer 8b). | -0.15 to +0.15 | 52% | Poor | Yes |
| Z3 | Freestanding | Makes contact at all times | Two points. Graphite jig surface is not treated (has no pyrocarbon layer 8b) | -0.15 to +0.25 | 81% | Poor | Yes |

| | | | | | | | |
|---|---|---|---|---|---|---|---|
| * When measuring the amount of warpage, the warpage that causes, as illustrated in Fig. 19, the recessed surface 5a side of the susceptor to result in a concave shape is defined as plus (solid line in the figure), while the warpage that causes the recessed surface 5a side of the susceptor to result in a convex shape is defined as minus (wavy line in the figure). | | | | | | | |

Table 1 indicates the following. When using the CVD apparatuses of Examples 1 and 2, the carbonaceous substrate makes contact with the main portion of the upper portion support member intermittently, so the problem that a portion of the carbonaceous substrate cannot be coated can be avoided (i.e., the carbonaceous substrate surface is uniformly coated with the SiC film). Accordingly, with the present invention susceptors A1 and The amount of warpage can be lessened, and the percentage of color unevenness occurrence can be suppressed. Therefore, the outer appearance can be kept in good condition. In addition, because the upper end of the carbonaceous substrate is supported by the two plate-shaped members, the carbonaceous substrate is restrained from displacement or the like at the early stage even when slight displacement occurs. As a result, the carbonaceous substrate can be prevented from falling over. Moreover, the SiC film can be prevented from peeling off from the susceptor when the present invention susceptor A1 or A2 is removed from the lower portion support member, because the pyrocarbon layer, which shows weaker peeling strength than the SiC film, is formed directly on the main portion of the lower portion support member or with expanded graphite interposed therebetween. In this case, the pyrocarbon may adhere to the susceptor side, but the pyrocarbon can be easily removed from the susceptor because the thermal expansion coefficient is greatly different between the SiC film and pyrocarbon.

In contrast, in the CVD apparatus shown in comparative example 1, the film formation is carried out while the extremely thin carbonaceous substrate is laid horizontally. For this reason, comparative susceptor Z1 showed warpage and curling, so the amount of warpage is considerably greater. The horizontal arrangement of the carbonaceous substrate means that the film formation is carried out while particles are on the recessed surface side. In addition, since the support pins are in contact with the carbonaceous substrate at all times, support marks remain thereon. For these reasons, comparative susceptor Z1 showed a large percentage of color unevenness. Furthermore, the SiC film is formed directly is on the carbonaceous substrate and the support pins. As a consequence, it was observed that the peeling of the SiC film occurred when the comparative susceptor Z1 was removed from the apparatus.

When using the CVD apparatus shown in comparative example 2, the carbonaceous substrate is shifted from the knife-edges and the carbonaceous substrate falls over or even the adjacent carbonaceous substrate may fall over. For this reason, comparative susceptor Z2 showed there were portions in which the SiC film was not formed, and as a consequence, it was observed that the percentage of color unevenness occurrence was higher. In addition, since the SiC film is not formed uniformly as described above, it was observed that comparative susceptor Z2 showed a greater amount of warpage. Furthermore, the SiC film is formed directly on the carbonaceous substrate and the knife-edges. As a consequence, it was observed that peeling of the SiC film occurred when comparative susceptor Z2 was removed from the apparatus.

When using the CVD apparatus shown in comparative example 3, the carbonaceous substrate is supported by the upper portion support member at all times (that is, the carbonaceous substrate and the upper portion support member are in contact with each other at all times). For this reason, a large stress tends to act on the carbonaceous substrate easily during the heat treatment. As a consequence, it was observed that comparative susceptor Z3 showed a greater amount of warpage. Moreover, the pyrocarbon film* is not formed on the surface of the lower portion support member. As a consequence, comparative susceptor Z3 showed a higher percentage of color unevenness occurrence. Furthermore, it was observed that peeling of the SiC film occurred when comparative susceptor Z3 was removed from the apparatus.

### INDJSTRIAL APPLICABILITY

The CVD apparatus according to the present invention can be used, for Example, to manufacture susceptors for semiconductor epitaxial growth.

### DESCRIPTION OF REFERENCE NUMERALS

- 5:: Carbonaceous substrate
- 6:: Lower portion support member
- 7:: Main portion
- 8:: Contact point portion
- 8a:: Main portion
- 8b:: Pyrocarbon layer
- 13:: Upper portion support member
- 13d:: Groove
- 13e:: Knife-edge

## Claims

1. A CVD apparatus for forming a SiC film on a surface of a carbonaceous substrate by introducing a gas into the apparatus while the carbonaceous substrate is being supported by a support member, **characterized in that**:
the support member has a lower portion support member on which the carbonaceous substrate is to be placed, the lower portion support member supporting a lower portion of the carbonaceous substrate, and an upper portion support member supporting an upper portion of the carbonaceous substrate; the upper portion support member is provided at an outer peripheral edge of the carbonaceous substrate and has two support plates; and the carbonaceous substrate is disposed with sufficient clearance in a carbonaceous substrate-accommodating space formed between the support plates.

2. The CVD apparatus according to claim 1, wherein the upper portion support member is disposed at an upper end position of the carbonaceous substrate.

3. The CVD apparatus according to claim 1 or 2, wherein the clearance is from 1 mm to 2 mm.

4. The CVD apparatus according to any one of claims 1 through 3, wherein, in the upper portion support member, the carbonaceous substrate-accommodating space formed by the two support plates of integral type has substantially a V-shape.

5. The CVD apparatus according to any one of claims 1 through 4, wherein the lower portion support member has a pyrocarbon layer on a surface thereof.

6. The CVD apparatus according to claim 5, further comprising a thermal expansion sheet provided between the lower portion support member and the pyrocarbon layer.

7. The CVD apparatus according to any one of claims through 6, wherein, when forming a SiC film on a surface of each of a plurality of the carbonaceous substrates, the carbonaceous substrates are disposed so as to be equidistant from the center of the apparatus.
